# EUROPEAN PATENT SPECIFICATION

(11) **EP 2 867 923 B1**
(45) Date of publication and mention of the grant of the patent: **15.01.2020**
(21) Application number: 12730212.3
(22) Date of filing: 27.06.2012
(51) Int. Cl.: H01L 27/146, G01S 17/89, G01N 21/64

(54) **IMAGE SENSOR AND APPARATUS COMPRISING SUCH IMAGE SENSOR**
BILDSENSOR UND VORRICHTUNG MIT SOLCH EINEM BILDSENSOR
CAPTEUR D'IMAGE ET APPAREIL COMPRENANT LEDIT CAPTEUR D'IMAGE

(43) Date of publication of application: 06.05.2015
(73) Proprietor: Teledyne Dalsa B.V., 5656 AE Eindhoven (NL)
(72) Inventor: BOSIERS, Jan, Edegem 2650 (BE)
(74) Representative: DeltaPatents B.V.
(86) International application number: PCT/EP2012/062497
(87) International publication number: WO 2014/000793

(56) References cited:
- EP-A1- 1 777 811
- EP-A1- 2 187 237
- EP-A2- 2 018 041
- US-A1- 2009 114 919
- US-B1- 6 825 455
- ALESSANDRO ESPOSITO: "Beyond Range: Innovating Fluorescence Microscopy", REMOTE SENSING, vol. 4, no. 12, 5 January 2012 (2012-01-05), pages 111-119, XP055054594, DOI: 10.3390/rs4010111

## Description

### FIELD OF THE INVENTION

The invention relates to an image sensor for fluorescent lifetime imaging. The invention further relates to a time-of-flight measurement apparatus comprising such image sensor. The invention further relates to a fluorescence lifetime measurement apparatus comprising such image sensor.

### BACKGROUND OF THE INVENTION

Charge-coupled devices (CCD's) are used for fluorescence lifetime imaging (FLIM) to detect the time constant of the decay of the stimulated emitted light from a biological sample or the phase shift between the emitted light and reflected light to determine distances. The latter is also called time-of-flight (ToF) imaging and is used in gaming, automotive, and security applications. A FLIM image sensor generally comprises image sensor cells having a respective toggle gate on opposite sides of a photo gate or photo diode. The toggle gates are operated (demodulating) with respective toggle gate (clock) signals having typically a 180° phase shift with respect to each other. Next to each toggle gate a respective collection well is located which may collect the electrons that were collected at the photo gate or generated at the photo diode. The collected electrons are directed to the direction of the toggle gate which has the highest potential (in case of holes this is in the direction of toggle gate with the lowest potential). Typical modulation frequencies are 20MHz. The target specification for certain FLIM applications is 80MHz. The maximum modulation frequency is determined to a large extend by the electric fields that that drive the electrons to the collection well.

The demand for higher demodulation frequencies conflicts with the demand for high fill factor, constant high demodulation efficiency and low power consumption, i.e. a high demodulation frequency requires a high fringing field under the photo gate to ensure a drift time that is short enough for the electrons. This in turn limits the length of the photo gate (which leads to a low fill factor) and requires a high voltage swing on the toggle gates (which leads to a high CV² power consumption) to achieve a high drift field to ensure the transit time of the electrons is short enough.

EP1,152,261A1 discloses a device and method for spatially resolved photodetection and demodulation of temporally modulated electromagnetic waves. Such method and device make it possible to measure phase, amplitude and offset of a temporally modulated, spatially coded radiation field. A micro-optical element spatially averages a portion of the scene and equally distributes the averaged intensity on two photo sites close to each other. Adjacent to each of these photo sites are two storage areas into which charge from the photo site can be moved quickly (with a speed of several MHz to several tens or even hundreds of MHz) and accumulated essentially free of noise. This is possible by employing the charge-coupled device (CCD) principle. The device can be operated in two modes for two types of modulated radiation fields: (1) sinusoidal radiation signals are demodulated by operating the photo sites and their storage areas in quadrature, i.e., by applying the clocking signals to the second photo site and its storage areas with a delay of a quarter of the repetition period compared to the first photo site and its storage areas; (2) pulsed radiation signals are measured by switching the first photo site's storage part from the first to the second area during the arrival of the radiation pulse, whereby the second photo site and its storage areas are used for offset measurements without emitted and received radiation. The device combines a high optical fill factor, insensitivity to offset errors, high sensitivity even with little light, simultaneous data acquisition, small pixel size and maximum efficiency in use of available signal photons for sinusoidal as well as pulsed radiation signals. Preferential use is in a time-of-flight (TOF) range imaging system without moving parts, offering 2D or 3D range data. A major disadvantage of this solution is that it requires an micro-optical element that spatially averages a portion of the scene and equally distributes the averaged intensity on two photo sites close to each other. Such element renders the device rather complex and costly.

EP1,624,491A1 discloses a solid-stage photosensor, wherein the effective photosensitive area can be controlled with a multitude of electrodes on top of an insulator layer covering a semiconductor substrate. Photo-generated charge carriers move laterally under the influence of the voltage distribution on the various electrodes and they are collected at the two ends of the photosensor in diffusions or in MOS structures. The voltage distribution on the electrodes is such that the voltage at the two furthermost electrodes is maximum (if photoelectrons are collected), minimum at an interior electrode, and monotonously decreasing in between. The lateral position of the electrode with minimum voltage defines the effective photosensitive area of the photosensor. Because of the compact nature of this photosensor, it can be used as pixel device in image sensors, either for dynamic exposure control, for optoelectronic mixing or for demodulation, such as required in optical time-of-flight range cameras. The disadvantage of this solution is that the power dissipation is quite high.

Document EP 2 018 041 A2 discloses a Time of Flight (TOF) sensor comprising a pixel structure provided with a photogate, two integration regions for receiving and storing photo-generated charges; modulation gates that moves the photogenerated charges from the photogate to be stored in the integration regions; and sense nodes, in which each of the sense nodes is associated with one of the integration region, into which the photogenerated charges are moved from the integration regions during a readout stage. Instead of first shifting the charge from the integration gate to the sense node and then reading-out the analog value, the device known from EP 2 018 041 A2 is configured to measure the time it takes from beginning of lowering the potential of the integration gate to when the charge starts flowing to the sense node.

Demodulating pixel structures are also known from US 6 825 455 B1, US 2009/114919 A1 and EP 2 187 237 A1.

A demodulation device is also known from EP 1 777 811 A1.

### SUMMARY OF THE INVENTION

The proposed invention offers a solution for both the earlier-described problems.

The invention is defined by the independent claim. The dependent claims define advantageous embodiments.

In accordance with a first aspect of the invention an image sensor for fluorescent lifetime imaging as described in claim 1 is provided.

The image sensor in accordance with the invention constitutes a significant improvement over the prior art devices. In the invention three (smaller) photo gates instead of one larger photo gate (effectively splitting the photo gate in at least three sub-gates) are used. Furthermore, by applying a relatively small clocking voltage to the outer photogates during the integration phase, the clocking voltage of the toggle gates can be significantly reduced while the minimum fringing fields under the photogates and toggle gates are increased. This is in contrast with EP1,624,491A1, wherein all photo gates during the integration phase of the pixel region are clocked. Also during the integration phase a DC-voltage is applied to the middle photo gate (or one of the remaining middle photo gates), wherein the DC-voltage is chosen such that it lies in between the extremes of the respective photo gate signals. By splitting the photo gate into different regions and giving the outer regions also a modulation voltage the local drift field (derivative of the channel potential) for the electrons in the channel under the photo gate region is increased, which enables the electrons to travel further within a certain modulation clock period. As a consequence the pixel size may be designed larger at a given clock frequency, which is also beneficial for the light sensitivity. In comparison with the prior art solutions which increase the voltage swing on the toggle gates there is also a significant power consumption reduction. But also in comparison with EP1,624,491A1 the power consumption is lower for a given CCD technology, because not all photo gates are clocked during the integration phase.

The invention becomes particularly advantageous in image sensors that are manufactured in double-poly or three-layer poly process. The plurality of sub-photogates can be exploited to get a fully-symmetrical pixel in terms of topology as well, which is beneficial for the performance.

In order to facilitate the understanding of the invention a few expressions are defined hereinafter.

The term "substrate" may denote any suitable material, such as a semiconductor, glass, plastic, etc. The term "substrate" may be used to define generally the elements for layers that underlie and/or overlie a layer or a portion of interest. Also, the substrate may be any other base on which a layer is formed, for example a semiconductor wafer such as a silicon wafer or silicon chip. A semiconductor substrate may comprise a material of the group comprising: a group IV semiconductor (such as silicon or germanium), and a group III-group V compound semiconductor (such as gallium arsenide).

The term "semiconductor device" may denote a transistor or a circuit comprising a plurality of transistors and interconnections. The transistor may be a field effect transistor for example.

The term "field effect transistor" (FET) may denote a transistor in which an output current (source-drain current) may be controlled by the voltage applied to a gate. Such FET structure may be an MOSFET. The semiconductor device can be any integrated circuit and may comprise logic circuitry, photo sensitive cells, memory cells, and the like. The material of the semiconductor structure may be silicon, germanium, or any other semiconductor material.

As the invention is related to image sensor cell design rather than circuits the description does not elaborate in much detail on the operation of CCD and CMOS imagers. Such knowledge is considered to be known to the person skilled in the art.

In an embodiment of the image sensor of the invention, in operational use, the respective photo voltage swing and the respective toggle voltage swing are chosen such that a minimum of the electrical drift field within the photo gate region is kept above a predefined threshold.

In an embodiment of the image sensor of the invention, in operational use, the outer photo gates have about half the voltage swing of the toggle gates.

In an embodiment of the image sensor of the invention is implemented in CCD technology. The invention is particularly advantageous in CCD technology, because in such technology no separate readout circuit per pixel is needed, but the imaging array is read-out sequentially using the CCD principle, towards an optional storage area, and then readout register that is connected to one readout amplifier. Thus the circuit complexity is minimized like in a full-frame or frame-transfer CCD and the fill-factor of the pixel is optimized. However, the invention is also applicable to so-called interline (IL) CCD image sensors.

An embodiment of the image sensor of the invention further comprises first driver circuitry for modulating the respective toggle gate signals.

An embodiment of the image sensor of the invention further comprises second driver circuitry for modulating the respective photo gate signals.

In accordance with a second aspect, the invention provides a time-of-flight measurement apparatus comprising the image sensor of the invention. In such application the invention is particularly advantageous.

In accordance with a third aspect, the invention provides a fluorescence lifetime measurement apparatus comprising the image sensor of the invention. In such application the invention is particularly advantageous.

### BRIEF DESCRIPTION OF THE DRAWINGS

These and other aspects of the invention are apparent from and will be elucidated with reference to the embodiments described hereinafter. In the drawings,
**Fig. 1** shows a pixel region of a known image sensor using horizontal toggling (modulation);
**Fig. 2** shows a pixel region of another known image sensor using vertical toggling (modulation);
**Fig. 3** shows a schematic layout of the gates of a pixel region of the known image sensor of **Fig. 2****;**
**Fig. 4** shows a schematic layout of an embodiment of an image sensor in accordance with the invention;
**Fig. 5** illustrates a possible improvement of a pixel region which is also applicable to the invention;
**Fig. 6** shows a photograph of a prototype of the image sensor, and
**Fig. 7** shows the principle of local drift field enhancement within the pixel.

It should be noted that items which have the same reference numbers in different Figures, have the same structural features and the same functions, or are the same signals. Where the function and/or structure of such an item has been explained, there is no necessity for repeated explanation thereof in the detailed description.

### List of Reference Numerals:

- 1: Pixel region of image sensor of the prior art
- 100: Photo gate
- 110,110': Toggle gate
- 121,121': Storage cell/storage region
- 130,130': Barrier gate
- 150,150': Storage (shift) register (comprising plurality of storage cells)
- EFD: Electron flow directions
- 120,120': Storage gate
- PHR: Photo gate region
- L1: Length of pixel region
- W1: Width of pixel region
- 1': Pixel region of image sensor of the invention
- 100-1: Outer gate of photo gate region
- 100-2: Middle gate of photo gate region
- 100-3: Outer gate of photo gate region
- S110,S110': Strap line (shunt line) for toggle gate
- S100-1: Strap line (shunt line) for outer photo gate
- S100-3: Strap line (shunt line) for outer photo gate
- VS1, VS2: Vertical strap lines for middle photo gate, storage gates, and barrier gates
- 160: Contacts
- 140: Windows in poly layer for reducing the parasitic capacitance
- 200: Image sensor array of image sensor
- 300: Storage array of image sensor
- PH: Channel potential
- X: Location in channel (orthogonal to direction of photo gates)
- 1-1,1-2,1-3: Pixels
- 110': Toggle gate at highest potential
- 5: Drift field direction in photo gate region
- 10-1: Channel potential values underneath outer photo gate region having lowest potential
- 10-2: Channel potential values underneath middle photo gate region
- 10-3: Channel potential values underneath outer photo gate region having highest potential
- 11: Channel potential underneath toggle gate having low voltage
- 11': Channel potential underneath toggle gate having high voltage
- 12,12': Channel potential underneath storage gate
- 13,13': Channel potential underneath barrier gate

### DETAILED EMBODIMENTS

While this invention is susceptible of embodiment in many different forms, there is shown in the drawings and will herein be described in detail one or more specific embodiments, with the understanding that the present disclosure is to be considered as exemplary of the principles of the invention and not intended to limit the invention to the specific embodiments shown and described.

The invention proposes to overcome the problems of the prior art by splitting the photo gate into at least three sections, the outer photo gates having a much lower voltage swing and the inner photo gate being at a predefined voltage, such that a fringing field (drift field) is present under the whole length of the photo gate (which also enables enlargement of the photo gate at a given modulation frequency). The invention also allows the reduction of the clock swing on the toggle gates. The total power consumption may be reduced by a factor of 3 in certain embodiments.

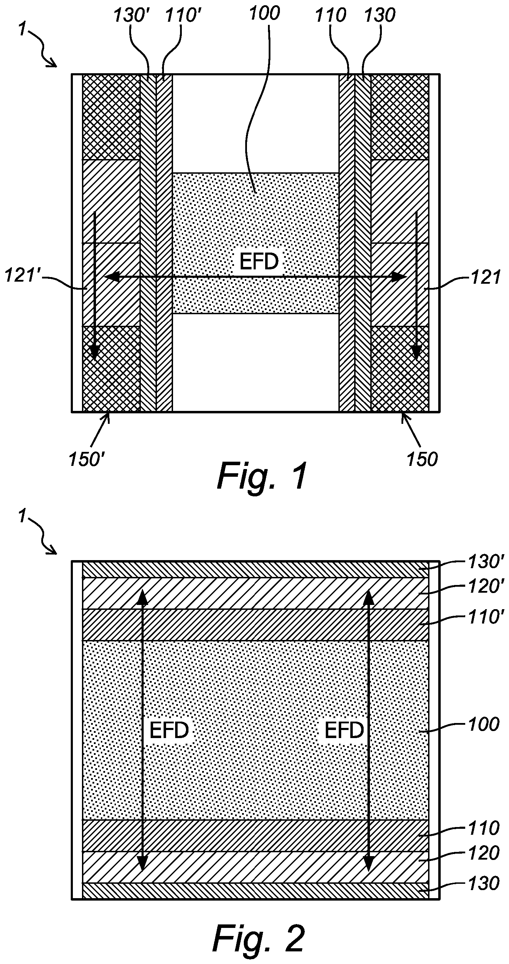

**Fig. 1** shows a pixel region of a known image sensor using horizontal toggling (modulation). An image sensor typically comprises a large array of such pixel regions, typically with resolutions up to 512. by 512. Pixels. A pixel region 1 of a demodulation-type image sensor using horizontal toggling, as in **Fig. 1****,** typically comprises a (transparent) photo gate 100 above a channel region having a vertically-oriented toggle gate 110,110' on each side thereof. Both the horizontal and the vertical direction are defined within a plane parallel to the substrate, in which the image sensor is made, in this description. Next to each toggle gates 110,110' there is a barrier gate 130,130' (blocking gate), separating the toggle gate 110,110' from a respective storage cell 121,121' which form part of a vertical read-out shift-register 150,150' (comprising a plurality of storage cells connected in series) which is used to read out the pixel region 1 and (vertically) transport the data to the output of the image sensor. Basically, the image sensor in which the cell of **Fig. 1** is used, is like an interline CCD sensor, albeit having two read-out shift registers per pixel region. The toggle gates 110,110' are continuously toggling resulting in the electron flow directions EFD as illustrated, i.e. electrons are alternatingly collected on the left side and on the right side, controlled by the high-frequency toggle gate signals (clocks). The advantage of the horizontal toggling sensor is that smear is very small when using pulsed illumination and when the toggling gates are continuously switching (no need to switch them off, which renders the circuit less complex). The disadvantage of such sensor is that, the cell is relatively complex, that the fill factor (photo sensitive region divided by total cell region) is strongly reduced by the vertical registers, Other disadvantages are the reduced well capacity in the well, and the reduced electrical field.

**Fig. 2** shows a pixel region of another known image sensor using vertical toggling (modulation). A pixel region 1 of a demodulation-type image sensor using vertical toggling, as in **Fig. 2****,** typically comprises a (transparent) horizontal photo gate 100 above a channel region having a horizontally-oriented toggle gate 110,110' on each side thereof. Next to each toggle gate 110,110' there is a storage gate 120,120', separating the toggle gate 110,110' from a respective barrier gate 130,130'. Basically, the image sensor in which the cell of **Fig. 2** is used, is like a full-frame or frame transfer CCD sensor. The toggle gates 110,110' are not continuously toggling at a high-frequency, namely only during the integration phase of the sensor. In the frame-transfer phase the photo gate 100, the toggle gates 110,110', the storage gates 120,120', and the barrier gates 130,130' are used to transfer the data to the storage area of the image sensor (frame-transfer CCD) or to the readout register (full-frame CCD).

Major advantages of such cell are relatively simple structure, the improved fill factor, the improved electrical field, and a higher well capacity. The disadvantage of such sensor is that it suffers from smear (generated when light falls on sensor during frame shift, which implies that a mechanical shutter may be required), and that the all gates are also used for vertical transport of the data, making the driving circuitry more complex.

The invention as will be explained later is applicable to both the horizontal as the vertical toggling image sensors. Hereinafter the invention will be explained on the basis of a vertical toggling version of the image sensor (which appeared to be the most advantageous during experiments carried out by the inventor). Such embodiment has the advantage of the higher fill factor (and therefore high light sensitivity). However, the invention is also applicable to the horizontal toggling version of the sensor. As the invention is related to the design of the pixel region (cell) rather than to the periphery, not much information is given in this description on those aspects. Such knowledge is well-known to the person skilled in the art.

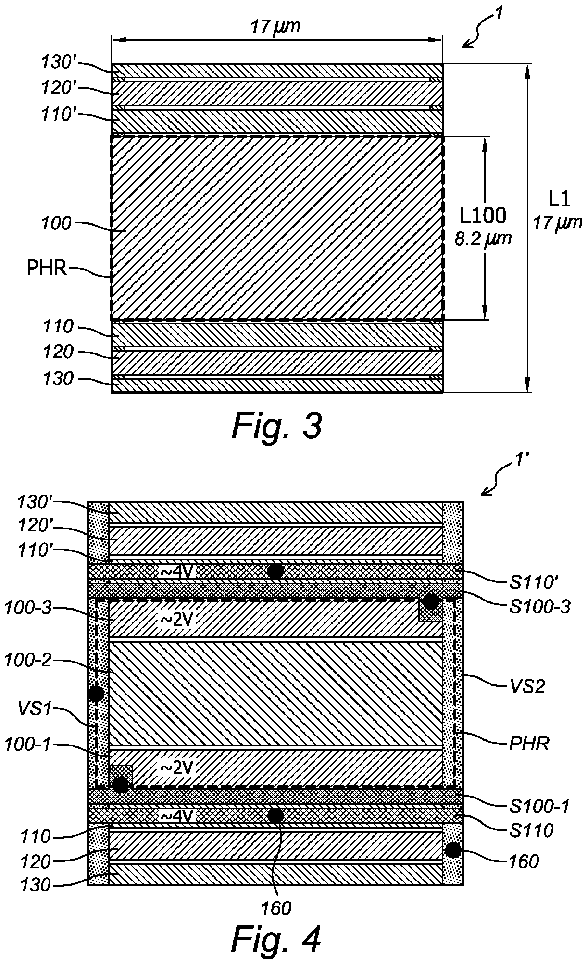

**Fig. 3** shows a schematic layout of the gates of a pixel region of the known image sensor of **Fig. 2****.** This figure illustrates some further definitions of the invention. The image sensor pixel region 1 typically has a photo gate region PHR, which is the region where light falls on the pixel 1. The photo gate region PHR is typically chosen such that it coincides with the photo gate 100, and therefore the photo gate region PHR typically has a length L100 equal to the width of the photo gate 100, and a width W1 equal to the width of the pixel region 1. However, the photo gate region PHR could also include (part of) the toggle gates 110,110' (which must be at least partially transparent gates as well in that case). In **Fig. 3** there is a shown a double-poly process, wherein the photo gate 100 and the storage gates 120,120' are manufactured in a first poly layer, and the toggle gates 110,110' and the barrier gates 130,130' are manufactured in a second poly layer. However, it must be noted that in such double-poly process technology the first and the second poly gates are not located in different layers, but substantially the same layer. In the topology however, there are some variations possible in gate dielectric layer thickness and spacer thickness. The layout of **Fig. 3** is the most tolerant for such variations in terms of performance, because the cell is fully symmetrical. Hardly visible in the drawing, but the boundaries of the cell are defined by a channel stop implant in the substrate. Such details, however, are considered to be well-known to the person skilled in the art. Given a demodulation frequency of 20MHz, the cell size is typically 17µm^{∗}17µm. In case of a larger cell, the drift speed of the electrons is becoming the limiting factor (due to a low drift field underneath the photo gate). This is where the invention comes in as will be explained later.

**Fig. 4** shows a schematic layout of an embodiment of an image sensor in accordance with the invention. This figure will be discussed in as far as it differs from **Fig. 3****.** Instead of a photo gate region PHR with one photo gate, the pixel region 1' comprises three photo gates 100-1, 100-2, 100-3. As is illustrated in **Fig. 4** the voltage swing on the respective gates in accordance with an embodiment of the invention is shown. The voltage swing on the toggle gates 110,110' (which are in anti-phase with each other) is about 4V. The voltage swing on outer photo gates 100-1, 100-3 (which are also in anti-phase with each other) is about half the swing of the toggle gates 110,110', namely 2V. And the middle photo gate 100-2 is tied to a predefined potential, such that the pre-defined DC-voltage is chosen such that a respective channel potential underneath the middle photo gate lies in between the extremes (maxima and minima) of the respective photo gate signals (during the integration phase). It is clear for the person skilled in the art, that when local implants are used, this may result in offsets to the gate voltages that need to be applied to obtain the required channel potential. **Fig. 4** further discloses some strap lines (shunt lines) for reducing the resistance of the respective gates when implemented in an imaging array. Such strap lines improve the electrical performance of the pixel region significantly (higher operation frequencies can be achieved). Contacts 160 between said strap lines and gates are schematically illustrated by the solid dots. In the embodiment of **Fig. 4****,** the following strap lines are included:
i) a horizontal strap line S110,S110' for each toggle gate 110,110' laid out in a first metallization layer;
ii) a horizontal strap line S100-1, S100-3 for each outer photo gate 100-1, 100-3 laid out in a second metallization layer, and
iii) respective vertical strap lines VS1, VS2 for the middle photo gate 100-2, the storage gates 120,120', and barrier gates 130,130' respectively. The vertical strap lines are laid out in a tungsten interconnect layer. It must be noted that the vertical strap lines VS1, VS2 are shared between neighboring cells and that the repetition rate (within a row of cells) of said gate contacts is therefore less than one per cell.

The cell size in **Fig. 4** is typically 24µm^{∗}24µm and the cells runs at a demodulation frequency of 80MHz. Such performance would not be feasible without the invention.

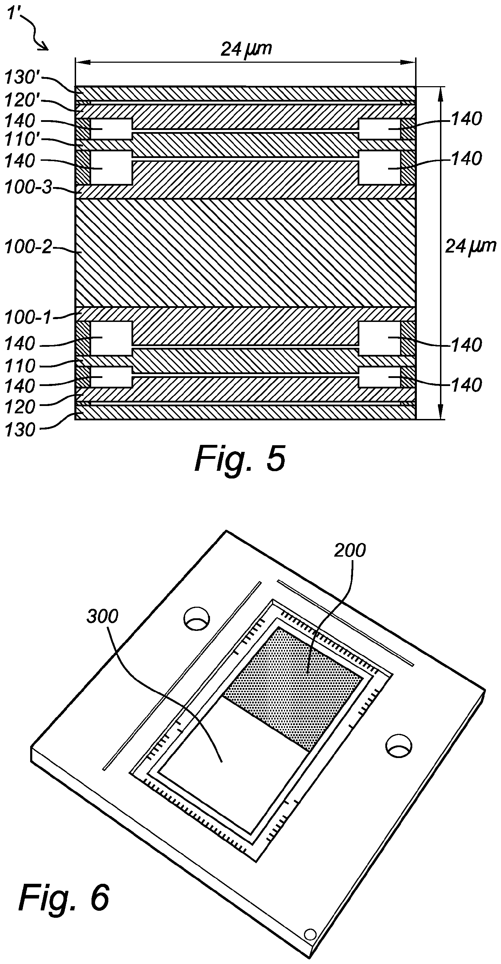

**Fig. 5** illustrates a possible improvement of a pixel region which is also applicable to the invention. The main difference with **Fig. 4** is that windows 140 are provided in the outer photo gates 100-1, 100-3, the toggle gates 110,110' and the barrier gates 120,120' for reducing the parasitic capacitance between the respective gates, with an additional benefit of increasing the light sensitivity.

**Fig. 6** shows a photograph of a prototype of the image sensor. The respective image sensor is a frame-transfer CCD image sensor using the vertical toggling principle. The image sensor comprises an image sensor array 200 comprising an array of demodulation pixel regions, each pixel sensing light through an aperture (not visible in figure), and a storage array 300 comprising an array of pixels that are covered (with a metal plate) such that they do not capture light.

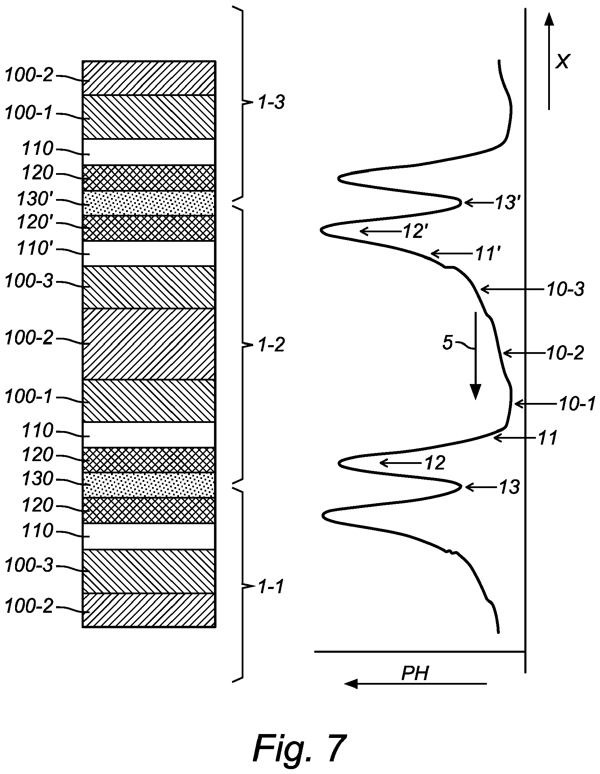

**Fig. 7** shows the principle of local drift field enhancement within the pixel. The figure shows a 3D-electrostatic simulation result of the channel potential PH underneath the gates as a function of the location in the channel of a pixel 1-1 of the invention, including two of its neighboring pixels 1-1, 1-3. In **Fig. 7** the storage gates 120,120' are all on a high potential (for example 10V). Hence, the channel potential 12,12' underneath the storage gates has a clear peak value. The fact that these peaks 12,12' in the channel are not of equal height is caused by the differences in gate potentials on the neighboring gates caused by 'fringing fields' . The barrier gates 130,130' are kept on 0V. Hence the much lower values 13,13' in the channel potential. In **Fig. 7** The upper toggle gate 110' is at a high potential (for example 10V) and the lower toggle gate 110 at a lower value (for example 0V) and hence the corresponding channel potential 11' is higher than the channel potential 11 underneath the lower toggle gate 110. Now, the important aspect of the invention is that the middle photo gate 100-2 is kept at a fixed potential (6V) during the integration phase.

In the state in Fig. 7 the upper outer photo gate 100-3 is toggled in synchronicity with the upper toggle gate 110', but with a lower voltage swing (for example half the swing of the toggle gate). Hence, the potential on this photo gate 100-3 is for example 8V in this example.

In the state in **Fig. 7** the lower outer photo gate 100-1 is toggled in synchronicity with the lower toggle gate 110, but with a lower voltage swing (for example half the swing of the toggle gate). Hence, the potential on this photo gate 100-1 is for example 4V in this example.

The consequence of the above is that within photo gate region underneath the photo gates there is a drift field 5 which is more constant (due to a more monotonous decrease of the channel potential 10-3, 10-2, 10-1 from one side to the other), and the minimum drift field is higher. To elucidate on this advantageous effect of the invention, simulations have been performed. With the prior art solutions the drift field in case of an 8V-toggle voltage swing was about 100V/cm, whereas with the invention the drift field in case of an even reduced(!) 4V/2V toggle voltage/outer photo gate voltage swing was 1000V/cm! The consequence is that the electrons travel faster. Moreover, the middle photo gate is not switched, which implies a power reduction in comparison with some known prior art solutions where all photo gates are switched. The invention may be further exploited in different manners (or a combination of the items in the list below):
1) Higher demodulation frequencies are possible;
2) larger cells sizes may be made (higher light sensitivity and/or dynamic range), and
3) Voltage levels on the respective gates may be lowered significantly, which reduces the power consumption and makes the generation of the driving pulses less complex.

Aspects such as the reading out of an image sensor are considered to be well-known to the person skilled in the art and are therefore not explained in this description.

It should be noted that the above-mentioned embodiments illustrate rather than limit the invention, and that those skilled in the art will be able to design many alternative embodiments.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. An image sensor for fluorescent lifetime imaging, the image sensor comprising:
an array of pixel regions (1'), each pixel region (1') having an aperture for receiving light from a modulated light source in an integration phase of the pixel region (1'), each pixel region (1') comprising:
a photo gate region (PHR) being embedded on opposite sides by two storage regions (120,120'), and two toggle gates, each toggle gate (110,110') being arranged between the photo gate region (PHR) and each respective one of the storage regions (120,120'); the photo gate region (PHR) comprising three photo gates (100-1,100-2,100-3) arranged parallel to each other and parallel to each respective toggle gate (110,110'); wherein
each respective toggle gate (110,110') carrying a respective toggle gate signal is configured to be modulated with a toggle voltage swing in synchronicity with the modulated light source and in anti-phase with respect to the other toggle gate; wherein
each of the outer ones of the three photo gates (100-1,100-3) is configured to carry a photo gate signal modulated with a photo voltage swing in synchronicity with its nearest toggle gate (110,110'), the photo voltage swing being lower than the toggle voltage swing; wherein
the middle photo gate (100-2) arranged between the outer photo gates is configured to be connected to a pre-defined DC-voltage during the integration phase, the pre-defined DC-voltage being chosen such that a respective channel potential underneath the middle photo gate lies in between channel potentials corresponding to the outer photo gates.

2. The image sensor as claimed in claim 1, wherein the outer photo gates (100-1,100-3) have half the voltage swing of the toggle gates (110,110').

3. The image sensor as claimed in any one of the preceding claims, which is implemented in CCD technology.

4. The image sensor as claimed in any one of the preceding claims, further comprising first driver circuitry for modulating the respective toggle gate signals.

5. The image sensor as claimed in any one of claims 1 to 4, the image sensor further comprising second driver circuitry for modulating the respective photo gate signals.

6. A time-of-flight measurement apparatus comprising the image sensor as claimed in any one of the preceding claims.

7. A fluorescence lifetime measurement apparatus comprising the image sensor as claimed in any one of claims 1 to 5.

## Patentansprüche

1. Ein Bildsensor zur Fluoreszenz-Lebensdauer-Bildgebung, wobei der Bildsensor umfasst:
eine Anordnung von Pixelbereichen (1'), wobei jeder Pixelbereich (1') eine Apertur zum Empfangen von Licht von einer modulierten Lichtquelle in einer Integrationsphase des Pixelbereichs (1') aufweist, wobei jeder Pixelbereich (1') umfasst:
einen Photogatebereich (PHR), der auf gegenüberliegenden Seiten durch zwei Speicherbereiche (120, 120') eingebettet ist, und zwei Togglegates, wobei jedes Togglegate (110, 110') zwischen dem Photogatebereich (PHR) und jedem jeweiligen der Speicherbereiche (120, 120') angeordnet ist; wobei der Photogatebereich (PHR) drei Photogates (100-1, 100-2, 100-3) umfasst, die parallel zueinander und parallel zu jedem jeweiligen Togglegate (110, 110') angeordnet sind; wobei
jedes jeweilige Togglegate (110, 110'), das ein jeweiliges Togglegatesignal übermittelt, dazu konfiguriert ist, mit einem Togglespannungshub in Synchronizität mit der modulierten Lichtquelle und in Gegenphase in Bezug auf das andere Togglegate moduliert zu werden; wobei
jedes der äußeren der drei Photogates (100-1, 100-3) dazu konfiguriert ist, ein Photogatesignal zu übermitteln, das mit einem Photospannungshub in Synchronizität mit dem ihm nächstliegenden Togglegate (110, 110') moduliert ist, wobei der Photospannungshub niedriger ist als der Togglespannungshub; wobei
das mittlere Photogate (100-2), das zwischen den äußeren Photogates angeordnet ist, dazu konfiguriert ist, während der Integrationsphase mit einer vordefinierten Gleichspannung verbunden zu werden, wobei die vordefinierte Gleichspannung derart ausgewählt wird, dass ein jeweiliges Kanalpotential unterhalb des mittleren Photogates zwischen Kanalpotentialen liegt, die den äußeren Photogates entsprechen.

2. Der Bildsensor nach Anspruch 1, wobei die äußeren Photogates (100-1, 100-3) den halben Spannungshub der Togglegates (110, 110') aufweisen.

3. Der Bildsensor nach einem der vorstehenden Ansprüche, der in CCD-Technologie implementiert ist.

4. Der Bildsensor nach einem der vorstehenden Ansprüche, der weiter erste Ansteuerschaltungen zum Modulieren der jeweiligen Togglegatesignale umfasst.

5. Der Bildsensor nach einem der Ansprüche 1 bis 4, wobei der Bildsensor weiter zweite Ansteuerschaltungen zum Modulieren der jeweiligen Photogatesignale umfasst.

6. Eine Flugzeit-Messeinrichtung, die den Bildsensor nach einem der vorstehenden Ansprüche umfasst.

7. Eine Fluoreszenz-Lebensdauer-Messeinrichtung, die den Bildsensor nach einem der Ansprüche 1 bis 5 umfasst.

## Revendications

1. Un capteur d'image pour imagerie de durée de vie fluorescente, le capteur d'image comprenant :
un réseau de régions de pixels (1'), chaque région de pixels (1') présentant une ouverture pour recevoir de la lumière d'une source de lumière modulée dans une phase d'intégration de la région de pixels (1'), chaque région de pixels (1') comprenant :
une région de portes photo (PHR) noyées sur les côtés opposés par deux régions de stockage (120, 120') et deux portes basculantes, chaque porte basculante (110, 110') étant agencée entre la région de portes photo (PHR) et chacune respective des régions de stockage (120, 120') ; la région de portes photo (PHR) comprenant trois portes photo (100-1, 100-2, 100-3) agencées parallèlement l'une à l'autre et parallèlement à chaque porte basculante respective (100, 110') ; dans lequel :
chaque porte basculante respective (110, 110') portant un signal de porte basculante respectif étant configurée pour être modulée avec une excursion de tension par bascule en synchronisme avec la source de lumière modulée et en antiphase par rapport à l'autre porte basculante ; dans lequel :
chacune de celles externes des trois portes photo (100-1, 100-3) est configurée pour porter un signal de porte photo modulé avec une excursion de tension photo en synchronisme avec sa porte basculante la plus proche (110, 110'), l'excursion de tension photo étant inférieure à l'excursion de tension par bascule ; dans lequel :
la porte photo centrale (100-2) agencée entre les portes photo externes est configurée pour être connectée à une tension CC prédéfinie au cours de la phase d'intégration, la tension CC prédéfinie étant choisie de sorte qu'un potentiel de canal respectif en dessous de la porte photo centrale se situe entre des potentiels de canaux correspondant aux portes photo externes.

2. Le capteur d'image selon la revendication 1, dans lequel les portes photo externes (100-1, 100-3) ont la moitié de l'excursion de tension des portes basculantes (110, 110').

3. Le capteur d'image selon l'une quelconque des revendications précédentes, qui est mis en œuvre en technologie CCD.

4. Le capteur d'image selon l'une quelconque des revendications précédentes, comprenant en outre une première circuiterie pilote pour moduler les signaux de portes basculantes respectifs.

5. Le capteur d'image selon l'une quelconque des revendications 1 à 4, le capteur d'image comprenant en outre une seconde circuiterie pilote pour moduler les signaux de portes photo respectifs.

6. Un appareil de mesure de temps de vol comprenant le capteur d'image selon l'une quelconque des revendications précédentes.

7. Un appareil de mesure de durée de vie de fluorescence comprenant le capteur de mesure selon l'une quelconque des revendications 1 à 5.
